Europäisches Patentamt

European Patent Office

Office européen des brevets

(19)

(11) Publication number: **0 104 371**
A2

# (12) EUROPEAN PATENT APPLICATION

(21) Application number: 83107713.6

(22) Date of filing: 04.08.83

(51) Int. Cl.³: **G 03 F 7/20**

(30) Priority: 30.08.82 US 412475

(43) Date of publication of application:
04.04.84 Bulletin 84/14

(84) Designated Contracting States:
CH DE FR GB IT LI NL

(71) Applicant: THE PERKIN-ELMER CORPORATION
Main Avenue
Norwalk Connecticut 06856(US)

(72) Inventor: Buckley, William D.
85 Delaware Road
Easton Connecticut(US)

(74) Representative: Patentanwälte Grünecker, Dr.
Kinkeldey, Dr. Stockmair, Dr. Schumann, Jakob, Dr.
Bezold, Meister, Hilgers, Dr. Meyer-Plath
Maximilianstrasse 58
D-8000 München 22(DE)

(54) Variable resolution X-ray lithography systems.

(57) This invention relates to an x-ray lithography system comprising a radiant energy source including an electron beam and an x-ray target, structure for mounting a wafer containing a resist thereon spaced from the energy source, structure for mounting a mask between the energy source and the wafer, and apparatus for adjusting the penumbra shadows on the wafer to match the minimum feature size on the mask, thereby maximizing the resolution with respect to throughput or the throughput with respect to resolution.

FIG. 3

EP 0 104 371 A2

## VARIABLE RESOLUTION X-RAY LITHOGRAPHY SYSTEMS

### Background of the Invention

This invention relates to x-ray lithography in general, and more particularly to method and apparatus for selectively varying the system resolution.

Various types of lithography have been used in the manufacture of integrated semiconductor circuits to expose photoresist, which has been deposited on the semiconductor wafer. As a result of the requirements for miniaturization, by placing more devices on a given chip, lithography has progressed toward shorter wavelengths, which are necessary to provide good resolution and small size. X-ray lithography has been proposed as a solution to the resolution problem because it has a particularly short wavelength, in the range from about 4 to 50 angstroms, and more usually in the range from about 4 to about 13 angstroms. In such lithography, a mask having the desired pattern thereon is interposed between the source of radiation and the semiconductor substrate coated with the resist on which the pattern is to be exposed.

Conventional x-ray lithography systems used a fixed electron beam spot size, which determined the limiting resolution of the system because of penumbral effects. The spot was generally fixed as large as possible to increase anode power dissipation and enhance x-ray flux in order to maximize throughput. It is an object of the present invention to provide a new and improved x-ray lithography system which provides good resolution characteristics when necessary and yet has good throughput features.

This and other advantages of the system of the invention, as compared to x-ray lithographic systems heretofore utilized for the above-stated purposes, will become apparent as the discussion proceeds.

## Summary of the Invention

Briefly, my invention contemplates the provision of a new and improved x-ray lithography system characterized by a radiant energy source which includes an electron beam and an x-ray target, means for mounting a wafer containing a resist thereon spaced from said energy source, and means for mounting a mask between said energy source and said wafer. Further, the system according to the invention includes means for varying the penumbra shadows on the wafer to match the minimum feature size on the mask, thereby maximizing the resolution with respect to throughput or the throughput with respect to resolution.

According to a feature of the invention the radiant energy source further includes means for varying the spot size of the electron beam on said x-ray target to adjust the penumbra shadows on the wafer.

According to another feature of the invention the means for adjusting the penumbra shadows on the wafer includes means for varying the mask to wafer gap or the energy source to mask gap.

Preferably, in one form of the invention, the radiant energy source generates tungsten M-line radiation.

In another form of the invention, there is provided a new and improved method of performing x-ray lithography comprising the steps of: mounting a wafer containing a resist thereon in spaced relationship from a radiant energy source, and mounting a mask between the radiant energy source and the wafer. The method according to the invention further inclues the steps of: directing an electron beam to strike an x-ray target to provide the radiant energy source, adjusting the penumbra shadows on the wafer to match the minimum feature size on the mask, thereby maximizing the resolution with respect to the throughput or the throughput with respect to resolution.

There has thus been outlined rather broadly the more important features of the invention in order that the detailed description thereof that follows may be better understood, and in order that the present contribution to the art may be better appreciated. There are, of course, additional features of the invention which will be described more fully hereinafter. Those skilled in the art will appreciate that the conception on which this disclosure is based may readily be utilized as the basis for other systems for carrying out the several purposes of the invention. It is important, therefore, that this disclosure be regarded as including such equivalent systems as do not depart from the spirit or scope of the invention.

Several embodiments of the invention has been chosen for purposes of illustration and description and are shown in the accompanying drawings, forming a part of the specification.

## Brief Description of the Drawings

Fig. 1 is a schematic side elevation showing an x-ray lithography system operating in a first mode;

Fig. 2 is a schematic side elevation showing an x-ray lithography system operating in a second mode; and

Fig. 3 is a side elevation showing a source of radiant energy for emitting x-rays, according to the concepts of the invention.

5

## Detailed Description of the Invention

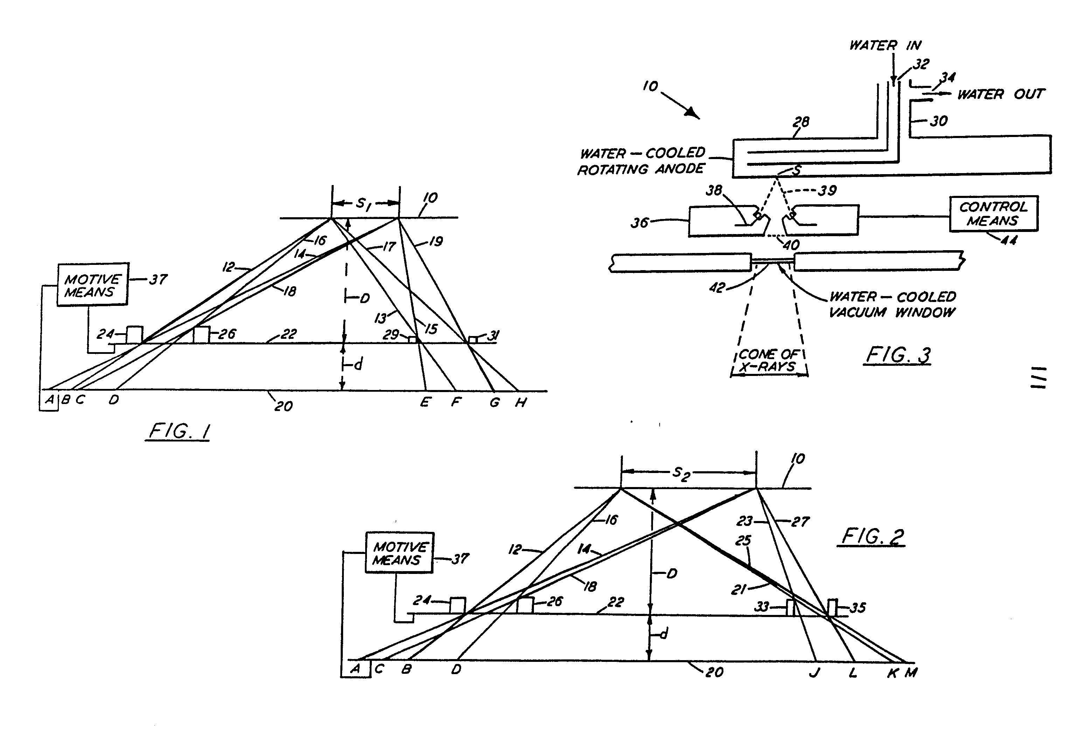

As best seen in Figs. 1 and 2 a radiant energy source 10 emits x-rays, as indicated at 12, 14, 16 and 18, and also at 13, 15, 17 and 19 in Fig. 1 and 21, 23, 25 and 27 in Fig. 2. The x-rays are directed toward a substrate or wafer 20 containing a resist thereon. Interposed betweeen the source 10 and the wafer 20 is a mask, generally indicated at 22, having features of absorber material 24, 26, such as gold, for example. Fig. 1 also shows features 29 and 31, while Fig. 2 also shows features 33 and 35. The absorber material absorbes the x-rays in those areas where it is present, thereby preventing the exposure in the corresponding areas of the resist. After exposure for the required length of time, the resist is then developed and further processing of the substrate carried out.

X-rays 12 and 14 form in cooperation with the inside corner of feature 24 a first penumbra shadow indicated at A-B. In a similar manner x-rays 16 and 18 form in cooperation with the outside corner of adjacent feature 26 a second penumbra shadow indicated at C-D. It is noted that the first penumbra shadow A-B does not overlap the second penumbra shadow C-D, but is spaced therefrom by the distance B-C. This is for a system, as illustrated in Fig. 1 wherein the electron beam spot size is $S_1$, the mask is located a distance D from the source 10 and the wafer is loacted a distance d from the mask.

Still referring to Fig. 1, x-rays 13 and 15 form in cooperation with the outisde corner of feature 29 a third penumbra shadow indicated at E-F.

X-rays 17 and 19 form in cooperation with the inside corner of adjacent feature 31 a fourth penumbra shadow indicated at G-H. It is noted that the third penumbra shadow E-F does not overlap the fourth penumbra shadow G-H, but is spaced therefrom by the distance F-G.

As seen in Fig. 2, the electron beam spot size $S_2$ is about double in diameter as compared to the spot size $S_1$ of Fig. 1. As a result, the first penumbra shadow A-B overlaps the second penumbra shadow C-D, therby limiting the resolution of the system because of the penumbral effects.

Still referring to Fig. 2, x-rays 21 and 23 form in cooperation with the outside corner of feature 33 a third penumbra shadow indicted at J-K. Also, x-rays 25 and 27 form in cooperation with the inside corner of feature 35 a fourth penumbra shadow indicated at L-M. As a result the third penumbra shadow J-K overlaps the second penumbra shadow L-M, as indicated at L-K. It is noted that the pneumbras would not overlap for more widely spaced, or lower resolution, features.

In practice it is usually necessary to operate with a penumbra smaller than the feature spacing. Therefore, the system of Fig. 1 would be an upper limit case. The system of Fig. 2 would usually not be used.

The invention permits varying the penumbra to match the minimum feature size on the mask, i.e., a mask with $0.5\mu$m features would use a different penumbra from one with $1\mu$m features. This permits selection of appropriate penumbra, resolution, for each of the several masks used in device fabrication or to select different penumbras for different integrated circuits, according to their requirements.

Heretofore, conventional x-ray lithography systems used a fixed electron beam spot size, which determined the limiting resolution of the system because of the penumbral effects. The spot was generally fixed as large as possible to increase the anode power dissipation and hence the x-ray flux in order to maximize throughput. According to the present invention, the system resolution can be selected by varying the electron beam spot size. The larger the spot the greater the power. This permits a trade-off of resolution and throughput. For larger features the resolution is reduced, thereby increasing throughput, and for smaller features the resolution is increased, thereby decreasing the throughput.

With reference to Figs. 1 and 2, in order to maximize the resolution and throughput, in one form of the invention, the electron beam spot size S is so selected that points B-C coincide as an upper limit. That is, as an upper limit, adjacent penumbra shadows for their adjacent features just touch each other or coincide, but do not overlap.

In order to implement this concept, in one form of the invention, an electron beam gun is provided with a variable focus capability. Referring to Fig. 3, the radiant energy source, indicated generally at 10, includes a water cooled rotatable anode 28 mounted on a shaft 30, which contains appropriate passages 32 and 34 for cooling water. The gun assembly 36 includes a filament 38 from which electrons 39 emit and strike an anode target 28. Also included is an electrostatic shield 40. A cone of x-rays passes through a water cooled vacuum window 42. Control means 44 vertically move the gun assembly 36 towards or away from the anode target 28 to adjust the electron beam spot size S. That is, the spot diameter may be electrostatically, manually or automatically adjusted by control means 44 to maximize the resolution with respect to throughput or the throughput with respect to resoluton.

In another form of the invention, in order to maximize the resolution and throughput by adjusting the penumbra shadows on the wafer to match the minimum feature size on the mask, the gap between the mask and wafer or between the energy source and mask is varied. Referring to Figure 1 and 2, motive means 37 are provided for selectively vertically moving either the mask 22 or th wafer 20 one with respect to the other or one with respect to the energy source 10. Any suitable motive means may be employed such as, for example, mechanical lever or screw arrangements or solenoides, etc. It is noted that the range of the variation in the mask to wafer gaps is limited because small gaps risk mask damage and large gaps may result in diffraction limited resolution. In addition changing the gap changes the image magnification and hence could produce poor overlay.

It will thus be seen that the present invention does indeed provide an improved system for x-ray lithography and effectively meets the objects specified hereinbefore.

Although certain particular embodiments of the invention are herein disclosed for purposes of explanation, further modifications thereof, after study of this specification, will be apparent to those skilled in the art to which the invention pertains.

Reference should accordingly be had to the appended Claims in determining the scope of the invention.

0104371

What is Claimed is:

1. An x-ray lithography system comprising a radiant energy source including means for forming an electron beam and an x-ray target, means for mounting a wafer containing a resist thereon spaced from said energy source, means for mounting a mask between said energy source and said wafer, and means for varying the penumbra shadows on the wafer to match the minimum feature size on the mask, thereby maximizing the resolution with respect to throughput or the throughput with respect to resolution.

2. An x-ray lithography system according to Claim 1 wherein said means for varying the penumbra shadows on the wafer includes means for varying the spot size of the electron beam on said x-ray target.

3. An x-ray lithography system according to Claim 1 wherein said means for varying the penumbra shadows on the wafer includes means for varying the gap between the mask and the wafer or between the energy source and mask.

4. An x-ray lithography system according to any one of Claims 1 to 3 wherein said radiant energy source generates tungsten M-line radiation.

5. An x-ray lithography system according to any one of Claims 1 to 3 wherein said target is selected from the group consisting of tungsten, alloys of tungsten, and tungsten compounds, so as to generate a tungsten M-line.

6. A method of operating an x-ray lithography system comprising the steps of mounting a wafer containing a resist thereon in spaced relationship from a radiant energy source, mounting a mask between said radiant energy source and said wafer, directing an electron beam to strike an x-ray target to provide said radiant energy source, adjusting the penumbra shadows on the wafer to match the minimum feature size on the mask, thereby maximizing the resolution with respect to throughput or the throughput with respect to resolution.

7. The method of Claim 6 wherein said radiant energy source generates tungsten M-line radiation.

8. The method of Claim 6 wherein said target is selected from the group consisting of tungsten, alloys of tungsten, and tungsten compounds, so as to generate a tungsten M-line.

FIG. 1

FIG. 2

WATER IN

WATER OUT

WATER—COOLED
ROTATING ANODE

CONTROL
MEANS

WATER—COOLED
VACUUM WINDOW

CONE OF
X-RAYS

FIG. 3

MOTIVE
MEANS

0104371